# EUROPEAN PATENT APPLICATION

(11) **EP 4 307 362 A1**
(43) Date of publication of application: **17.01.2024**
(21) Application number: 23183054.8
(22) Date of filing: 03.07.2023
(51) Int. Cl.: H01L 23/31, H01L 23/40

(54) **HIGH RELIABILITY SEMICONDUCTOR PACKAGE DESIGN**

(30) Priority: 11.07.2022 US 202217861675
(71) Applicant: Littelfuse, Inc., Chicago, IL 60631 (US)
(72) Inventor: Spann, Thomas, Chicago, 60631 (US)
(74) Representative: Arnold & Siedsma

(57) **Abstract**

A power semiconductor device package. The package may include a baseplate that has a plurality of through holes. The package may also include an insulating body, affixed to a top side of the baseplate The insulating body may include a main portion, to enclose a set of semiconductor devices therein, and a plurality of locking structures, the plurality of locking structures disposed along a lower periphery of the main portion, and integrally formed within the insulating body, wherein the plurality of locking structures extend through the baseplate.

## Description

### Background

### Field

There are numerous power semiconductor package designs, where these designs include several visible elements, forming the outer design: 1. a baseplate, with two main functions: to support the unit mechanically and to provide thermal management; 2. power terminals and signal terminals, which terminals are used to conduct the electrical current; 3. an epoxy body, which body assures mechanical support and electrical insulation as well as protection of inner circuitry against environmental conditions. The inner design of a known semiconductor package mainly consists of semiconductor chips and elements as substrates, terminals, wires and/or clips. There are through hole technology (THT) as well as surface mounted device (SMD) packages, designed with and without screw holes, and screwable packages with concentric screw holes as well as long holes for the assembly to heatsinks. Typically, these screwable packages include nuts that are disposed inside nut cavities to facilitate placement of a busbar assembly on the top side.

In the known package designs, due to thermomechanical stress inside the epoxy package, caused by temperature cycling and power cycling with consecutive temperature cycling, delamination between the epoxy and the baseplate may occur. One disadvantage of the technology of known semiconductor packages having screw holes: In particular the screw elements that couple to the heatsink as well as the busbar assembly are prone to increase the inner stress and delamination in addition. Tensile and shear stress components inside the unit are mainly caused by the mounting torque of the screws as well as the opposite direction of tensile force vectors. As a consequence, delamination between the inner chips and the surrounding epoxy, as well as between substrate and epoxy may occur. Moreover, chip and substrate cracking may result.

### Brief Summary

At least one embodiment includes a power semiconductor device package. The package may include a baseplate that has a plurality of through holes. The package may also include an insulating body, affixed to a top side of the baseplate. The insulating body may include a main portion, to enclose a set of semiconductor devices therein, and a plurality of locking structures, the plurality of locking structures disposed along a lower periphery of the main portion, and integrally formed within the insulating body, wherein the plurality of locking structures extend through the base plate.

In another embodiment, a semiconductor device package assembly is provided, including a heatsink, a baseplate, affixed to the heatsink, and an insulating body, affixed to a top side of the baseplate. The insulating body may include a main portion, to enclose a set of semiconductor devices therein, and a plurality of locking structures that are disposed along a lower periphery of the main portion, and integrally formed within the insulating body, wherein the plurality of locking structures extend through the base plate.

In another embodiment, a method of fabricating a semiconductor device package assembly is provided. The method may include providing a baseplate, the baseplate comprising a plurality of through holes and a plurality of lock holes, affixing a semiconductor device assembly to the baseplate, where the semiconductor device assembly comprising at least one semiconductor die, affixed to a substrate. The method may further include affixing an insulating body to the baseplate, wherein the insulating body surrounds the semiconductor device assembly, wherein the affixing the insulating body comprises: forming the insulating body as a monolithic moldable material, wherein the monolithic moldable material flows into the plurality of lock holes.

### Brief Description of the Drawings

**FIG. 1** shows a schematic of a conventional semiconductor device module;
**FIG. 2** shows a schematic of forces acting on a semiconductor device package as in the semiconductor device module of FIG. 1;
**FIG. 3** shows a scenario of delamination of the semiconductor device package of FIG. 2;
**FIG. 4A** shows a side cross-sectional view of a semiconductor device package, according to embodiments of the disclosure;
**FIG. 4B** shows a close-up of a locking structure of the semiconductor device package of FIG. 4A, according to embodiments of the disclosure;
**FIG. 5A** shows a top view of a portion of a semiconductor device package, according to an embodiment of the disclosure;
**FIG. 5B** shows a top view of a portion of a further semiconductor device package, according to an embodiment of the disclosure; and
**FIG. 6** shows a top isometric view of a semiconductor device package, according to another embodiment of the disclosure.

### Description of Embodiments

The present embodiments will now be described more fully hereinafter with reference to the accompanying drawings, in which exemplary embodiments are shown. The embodiments are not to be construed as limited to the embodiments set forth herein. Rather, these embodiments are provided so that this disclosure will be thorough and complete, and will fully convey their scope to those skilled in the art. In the drawings, like numbers refer to like elements throughout.

In the following description and/or claims, the terms "on," "overlying," "disposed on" and "over" may be used in the following description and claims. "On," "overlying," "disposed on" and "over" may be used to indicate that two or more elements are in direct physical contact with one another. Also, the term "on,", "overlying," "disposed on," and "over", may mean that two or more elements are not in direct contact with one another. For example, "over" may mean that one element is above another element while not contacting one another and may have another element or elements in between the two elements. Furthermore, the term "and/or" may mean "and", it may mean "or", it may mean "exclusive-or", it may mean "one", it may mean "some, but not all", it may mean "neither", and/or it may mean "both", although the scope of claimed subject matter is not limited in this respect.

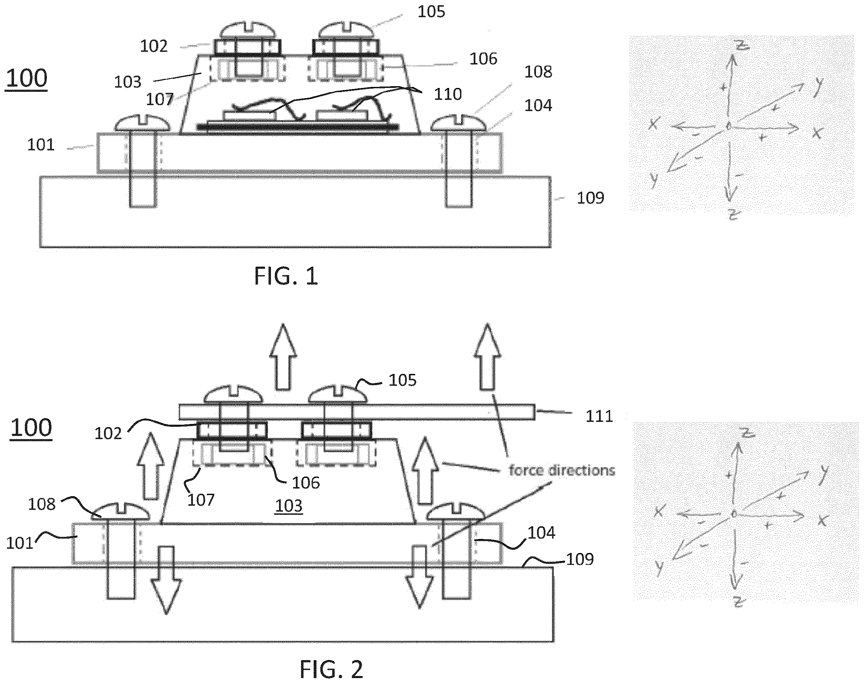

**FIG. 1** illustrates a schematic of a reference part, shown as semiconductor device module 100, arranged according to conventional technology. The semiconductor device module 100 includes a heatsink 109, baseplate 101 affixed to the heatsink 109, using a pair of screws 108 that extend within through holes 104. A body 103 is affixed to the baseplate 101, such as an epoxy body. Generally, the body 103 may be formed of a transfer mold compound. A set of semiconductor devices 110 are housed within the body 103. Terminals 102 are embedded by epoxy into the body 103, using screws 105 and nuts 106. The nuts 106 are located inside cavities 107. Optionally, screws 105 may be already placed.

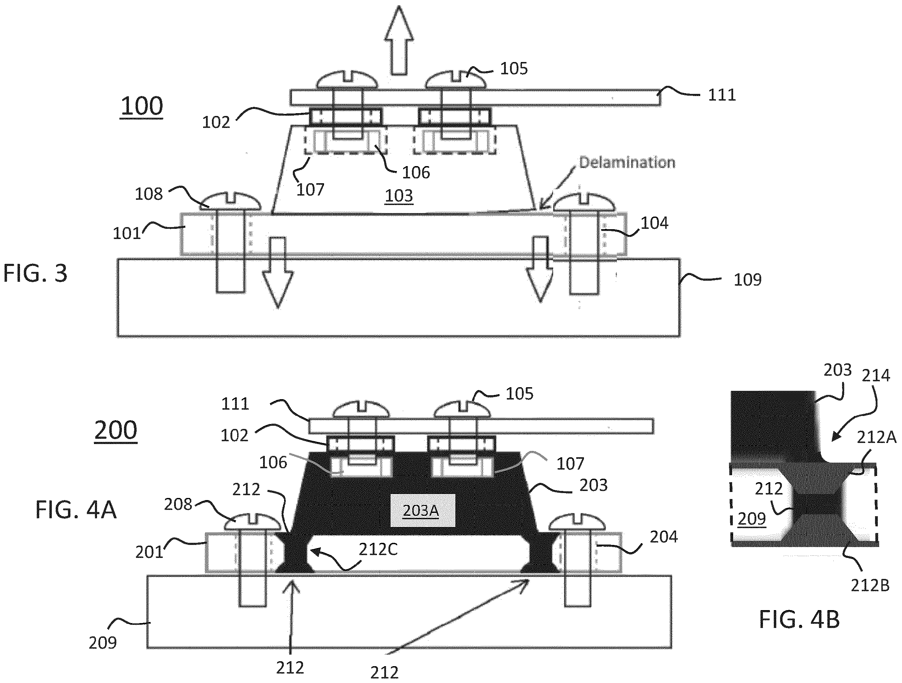

**FIG. 2** shows a schematic of forces acting on a semiconductor device package as in the semiconductor device module 100 of FIG. 1. In this example, a busbar 111 is attached to the terminals 102. FIG. 2 also shows the directions of forces that may act upon the semiconductor device module 100. In particular, due to thermomechanical stress inside the epoxy package, caused by temperature cycling and power cycling with consecutive temperature cycling, delamination between the epoxy and the baseplate may occur. In an extreme example, **FIG. 3** shows a scenario of delamination of the semiconductor device package of FIG. 2. This scenario highlights a disadvantage of the semiconductor device module 100. Especially the elements used to fasten the baseplate 101 to the heatsink 109, as well as the busbar assembly are able to increase the inner stress leading to possible delamination. Tensile and shear stress components inside the semiconductor device module 100 may thus lead to delamination as indicated by the arrows acting in the Z-direction of the Cartesian coordinate system shown. Forces may also be present acting in the X- and y directions that tend to cause delamination.

In various embodiments of the present disclosure, a novel body structure and baseplate structure are provided in order to reduce the delamination of semiconductor package modules. As detailed below, these embodiments may include lock holes within the baseplate, in particular, having a chamfer shape. These lock holes are designed to keep the baseplate and an epoxy body together. In some embodiments, as detailed below, these lock holes are filled with epoxy and are positioned underneath a screw head or a head portion of another type of fastener. This design feature reduces the tendency for delamination in that the screw elements may force the body to remain in place and well connected to the baseplate.

Turning now to **FIG. 4A** there is shown a side cross-sectional view of a semiconductor device package 200, according to embodiments of the disclosure. The semiconductor device package 200 may include a baseplate 201, where the baseplate 201 include a plurality of through holes. Two through holes are shown as through holes 204 in FIG. 4A. The semiconductor device package 200 may also include an insulating body 203, such as an epoxy body or a body made of another suitable material. As shown, the insulating body 203 is affixed to a top side of the baseplate 201. The insulating body 203 includes a main portion 203A, which portion may act as a housing, in order to enclose a set of semiconductor devices therein. The main portion 203A of the insulating body 203 is not shown in cross-section, and accordingly, these devices are not visible in FIG. 4A, but see FIG. 1 for an example of semiconductor devices. In various embodiments, various semiconductor devices, e.g. thyristors, diodes, etc. may be contained in the insulating body 203.

The insulating body 203 further includes a plurality of locking structures, shown as locking structures 212, where the plurality of locking structures are disposed along a lower periphery of the main portion 203A. Note that the locking structures 212 may be integrally formed within the insulating body 203, where the locking structures 212 are filled with epoxy that is bonded to the main portion 203A, in a manner that the epoxy extends through the base plate 201. Said differently, the locking structures 212 are formed by filling a set of locking holes 212C that are initially present in the base plate 201 and are subsequently filled with an epoxy material, or other material that is the same as the material of the insulating body. As such, the insulating body 203 may be formed from a flowable, moldable, or viscous precursor material, wherein the insulating body 203 may be formed into a complex shape, including the main portion 203A and locking structures 212 that are integrally formed with the main portion 203A. Said differently, the insulating body 203 includes the main portion 203 plus 'n' locking structures 212 that are together formed in one processing step, where the value of n may be 2, 4, 6, or other suitable number depending upon the exact design of the semiconductor device package.

As shown in FIG. 4A, and in more detail in FIG. 4B, the locking structure 212 may have a chamfer shape, at least on a lower portion. In FIG. 4B, an upper chamfered portion 212A is present, as well as a lower chamfered portion 212B. These portions serve to mechanically lock the main portion 203A to the baseplate 201. As further shown in FIG. 4B, rather than forming a sharp angle with the locking structure and top of baseplate 201, the insulating body 203 may be designed with a suitable radius in a curved portion 214 that extends between the main portion 203A and the locking structure 212, providing for additional stress reduction, less delamination and less crack initiation.

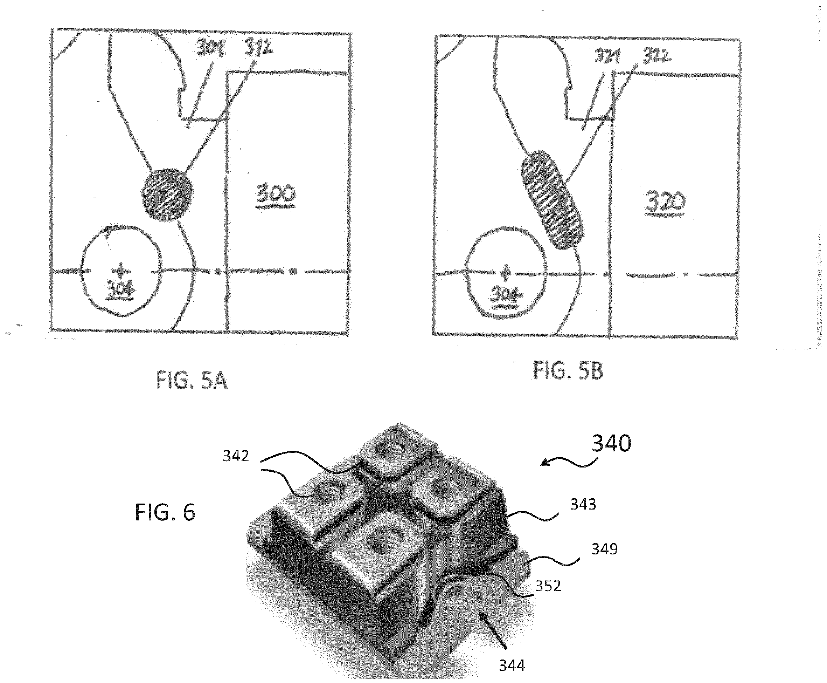

In various embodiments, the chamfered portions of a locking structure may have various types of shapes as viewed within a main plane of the baseplate. **FIG. 5A** shows a top view of a portion of a semiconductor device package, while **FIG. 5B** shows a top view of a portion of a further semiconductor device package, and **FIG. 6** shows a top isometric view of a semiconductor device package, where each of these figures is arranged according to a different embodiment of the disclosure. In FIG. 5A, the semiconductor device package 300 includes a baseplate 301, through hole 304, as well as a locking structure 312, having a circular shape within the main plane of the baseplate 301 (plane of the page). In FIG. 5B, the semiconductor device package 320 includes a baseplate 321, through hole 304, as well as a locking structure 322, having an elongated shape. In FIG. 6, the semiconductor device package 340 includes a baseplate 349, insulating body 343, terminals 342, through hole 344, as well as a locking structure 352, having a boomerang shape. In all these embodiments of FIG. 5A, FIG. 5B and FIG. 6, the respective locking structures may be disposed in a position that lies adjacent to a given through hole. Moreover, in all these embodiments the respective locking structures may have a chamfer shape when viewed in cross-section, as generally represented in FIG. 4A and FIG. 4B. In various additional embodiments, any type of locking structure design is possible if the design provides for locking the main portion of an insulating body and a baseplate. Such additional embodiments may include rectangular structures, cubic structures, kegel structures, or trapezoidal structures, to name a few non-limiting examples.

As discussed above, a given baseplate may be affixed to a heatsink, disposed subjacent to the baseplate, using a plurality of fasteners, disposed within a plurality of through holes, respectively. The fasteners may be screws, bolts, or similar fasteners. Returning to FIG. 4A, there is shown an embodiment where a plurality of screws, shown as screws 208 are disposed in the through holes 204, and are used as fasteners to affix the baseplate 201 to heatsink 209. As shown in FIG. 4A, by providing locking structures 212 that have a chamfer shape, the head of a screw or similar fastener, located in a nearby through hole, may extend above a portion of an adjacent locking structure. Thus, when the screws 208 are tightened to affix the baseplate 201 to heatsink 209, the head of the screws 208 also exert a force on the top of an upper surface of locking structures 212, and may further act as a stop that prevents the locking structures 212 from moving upwardly and accordingly prevents the main portion 203A from delamination with respect to baseplate 201. The same will apply to the embodiments of FIGs. 5A-6 when suitable fasteners are applied through the respective through holes in order to fasten the respective baseplates to a heatsink.

While the present embodiments have been disclosed with reference to certain embodiments, numerous modifications, alterations and changes to the described embodiments are possible while not departing from the sphere and scope of the present disclosure, as defined in the appended claims. Accordingly, the present embodiments are not to be limited to the described embodiments and may have the full scope defined by the language of the following claims, and equivalents thereof.

## Claims

1. A semiconductor device package, comprising:
a baseplate, the baseplate comprising a plurality of through holes; and
an insulating body, affixed to a top side of the base plate, the insulating body comprising:
a main portion, to enclose a set of semiconductor devices therein; and
a plurality of locking structures, the plurality of locking structures disposed along a lower periphery of the main portion, and integrally formed within the insulating body, wherein the plurality of locking structures extend through the base plate.

2. The semiconductor device package of claim 1, wherein the plurality of locking structure comprise a chamfer shape, at least on a lower portion of the plurality of locking structures.

3. The semiconductor device package of claim 1 or 2, wherein the plurality of locking structures comprise a circular shape within a main plane of the base plate.

4. The semiconductor device package of any of the preceding claims, wherein the plurality of locking structures comprise an elongated shape within a main plane of the base plate.

5. The semiconductor device package of any of the preceding claims, wherein the plurality of locking structures comprise a boomerang shape within a main plane of the base plate.

6. The semiconductor device package of any of the preceding claims, wherein the plurality of locking structures are disposed in a plurality of positions that lie adjacent to the plurality of through holes, respectively.

7. The semiconductor device package of any of the preceding claims, further comprising:
a heatsink, disposed subjacent to the base plate; and
a plurality of fasteners, disposed within the plurality of through holes, respectively, and affixing the base plate to the heat sink, preferably wherein a given fastener of the plurality of fasteners comprises a head portion that extends over an upper surface of an adjacent locking structure of the plurality of locking structures.

8. A semiconductor device package assembly, comprising:
a heatsink;
a baseplate, affixed to the heatsink; and
an insulating body, affixed to a top side of the baseplate, the insulating body comprising:
a main portion, to enclose a set of semiconductor devices therein; and
a plurality of locking structures, the plurality of locking structures disposed along a lower periphery of the main portion, and integrally formed within the insulating body, wherein the plurality of locking structures extend through the baseplate.

9. The semiconductor device package assembly of claim 8, wherein the plurality of locking structures comprise one or more of the following:
a chamfer shape, at least on a lower portion of the plurality of locking structures,
a circular shape, an elongated shape or a boomerang shape within a main plane of the baseplate.

10. The semiconductor device package assembly of claim 8 or 9, wherein the plurality of locking structures are disposed in a plurality of positions that lie adjacent to the plurality of through holes, respectively.

11. The semiconductor device package assembly of any of the claims 8-10, wherein the baseplate comprises a plurality of through holes, wherein the baseplate is affixed to the heat sink using a plurality of fasteners, disposed within the plurality of through holes.

12. The semiconductor device package assembly of claim 11, wherein a given fastener of the plurality of fasteners comprises a head portion that extends over an upper surface of an adjacent locking structure of the plurality of locking structures.

13. The semiconductor device package assembly of any of the preceding claims 8-12, the insulating body further comprising a terminal connection assembly, disposed in an upper portion of the insulating body.

14. A method of fabricating a semiconductor device package assembly, comprising:
providing a baseplate, the baseplate comprising a plurality of through holes and a plurality of lock holes;
affixing a semiconductor device assembly to the baseplate, the semiconductor device assembly comprising at least one semiconductor die, affixed to a substrate; and
affixing an insulating body to the baseplate, wherein the insulating body surrounds the semiconductor device assembly, wherein the affixing the insulating body comprises:
forming the insulating body as a monolithic moldable material, wherein the monolithic moldable material flows into the plurality of lock holes.

15. The method of claim 14, wherein the plurality of lock holes comprise a chamfer shape and/or further comprising:
affixing the baseplate to a heatsink using a plurality of fasteners that extend through the plurality of through holes, respectively, wherein a given fastener of the plurality of fasteners comprises a head portion that extends over a portion of a given lock hole of the plurality of lock holes.
